# EUROPÄISCHE PATENTANMELDUNG

(11) **EP 0 865 231 A1**
(43) Veröffentlichungstag der Anmeldung: **16.09.1998**
(21) Anmeldenummer: 98810202.6
(22) Anmeldetag: 10.03.1998
(51) Int. Cl.: H05K 3/00, H05K 3/42, H05K 3/40

(54) **Verfahren zum Herstellen von Leiterplatten mit Durchkontaktierungen**

(30) Priorität: 14.03.1997 EP 97104365
(71) Anmelder: Photo Print Electronic GmbH, 79650 Schopfheim (DE)
(72) Erfinder: Kersten, Peter, Dr.-Ing., 79689 Maulburg (DE); Kiefer, Jörg, Dipl.-Ing. (Univ.), 79669 Zell im Wiesental (DE)
(74) Vertreter: Morstadt, Volker, Dipl.-Ing.

(57) **Zusammenfassung**

Zur Vermeidung von Problemen, die durch Schwinden beim Aushärten von Füllmaterial entstehen, wird beim Herstellen von Leiterplatten (1) mit mindestens einer elektrisch leitenden Durchkontaktierung, die in einer Bohrung eines isolierenden Basis-Materials (2) von der einen (21) zur anderen Oberfläche (21, 22) verläuft, wie folgt vorgegangen: Das Basis-Material wird auf den Oberflächen mit zweischichtigen Folien (3, 4), von der eine erste Schicht aus einer Cu-Folie (31, 41) und eine zweite Schicht (32, 42) aus einer Cu-Schicht (32', 42'), einer Acrylnitril-Butadien-Styrol-Mischpolymerisat-Schicht (32", 42") oder aus einer selbsthaftenden Kunststoffschicht (32*, 42*) besteht, derart verpreßt, daß die Cu-Folien am Basis-Material gut haften. Die Bohrungen werden erzeugt. Diese und die freiliegenden Oberfläche der Schichten (32', 42'; 32", 42"; 32*, 42*) werden mit Cu-Schichten (6, 6') versehen. Die metallisierten Bohrungen werden mit einem Isoliermaterial (7) oder mit einem Leitmaterial (7') vollständig gefüllt. Die Schichten (32', 42'; 32", 42"; 32*, 42*) werden zusammen mit den Cu-Schichten (6, 6') entfernt. Über die verbleibenden Cu-Folien überstehende Stubs (71, 72; 81, 82) des Isoliermaterials oder des Leitmaterials werden nach dessen Aushärten entfernt und somit die Oberflächen der Cu-Folien planarisiert. Diese werden in üblicher Weise zur Herstellung von Leitungsmustern strukturiert.

## Beschreibung

Die Erfindung betrifft Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft.

Eine derartige Durchkontaktierung einer Leiterplatte dient z.B. dazu, eine elektrisch leitende Verbindung zwischen einer auf der ersten Oberfläche verlaufenden Leitbahn und einer auf der zweiten Oberfläche verlaufenden Leitbahn herzustellen, so daß auf beiden Oberflächen elektronische Komponenten angebracht werden können, die untereinander gemäß einer zu realisierenden Schaltung miteinander verbunden werden können.

Üblicherweise handelt es sich bei den Durchkontaktierungen um in der Leiterplatte an vom Layout der zu realisierenden Schaltung vorgegebenen Stellen angebrachte Bohrungen, deren Innenseiten metallisiert sind.

Solange auf den Leiterplatten nur Komponenten mit Anschlußdrähten oder -beinchen (Widerstände, Kondensatoren, Spulen, Übertrager, Dioden, Transistoren, integrierte Schaltungen etc.) anzubringen waren, konnten die Anschlußdrähte oder -beinchen direkt in die metallisierten Bohrungen eingesetzt und darin verlötet werden. Heutige Komponenten sind jedoch fast ausschließlich SMD-Komponenten. (Das Akronym SMD ist aus dem englischen Begriff surface mounted device gebildet.)

Im Gegensatz zu Komponenten mit Anschlußdrähten oder -beinchen haben SMD-Komponenten nur noch Anschlußpads. Diese werden flach auf Leitbahnen von Leiterplatten aufgelötet. Die durch die Metallisierung nicht verschlossenen, also offenen, Bohrungen werden durch dieses Verlöten nicht verschlossen und bleiben offen.

Wenn mehrlagige Leiterplatten mit Durchkontaktierungen herzustellen sind, die nur durch einen Teil der Lagen gehen und durch äußere Lagen überdeckt sind, würde die in den offenen Bohrungen durch das Überdecken verbleibende Luft sich bei einer Temperaturerhöhung ausdehnen und innere Risse hervorrufen können.

Es ist daher zwingend, die metallisierten Bohrungen zu verschließen. Wenn dies mittels Siebdrucks erfolgt, bei dem bekanntlich mit einer Rakel ein pastöses oder ähnlich konsistentes Material durch eine Schablone hindurchgedrückt wird, schwinden hierfür zur Verfügung stehende Materialien beim Aushärten, und es bildet sich auf dem in einer Bohrung zurückbleibenden Material eine Mulde. Diese ist aus den bei der Überdeckung von nichtgefüllten Bohrungen erwähnten Gründen ebenfalls sehr störend.

Zur Lösung der geschilderten Probleme besteht eine erste Variante der Erfindung in einem Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten:
- das Basis-Material wird
   -- entweder auf der ersten und/oder auf der zweiten Oberfläche mit einer ersten bzw. mit einer zweiten zweischichtigen Folie, von der eine erste Schicht aus einer Cu-Folie und eine zweite Schicht aus einer Cu-Schicht besteht, derart verpreßt, daß die Cu-Folien am Basis-Material gut haften,
   -- oder mit einer ersten bzw. mit einer zweiten Cu-Folie verpreßt, und darauf wird eine erste bzw. eine zweite Cu-Schicht aufgebracht,
- es werden die Bohrungen erzeugt,
- diese und die freiliegende Oberfläche der ersten bzw. der zweiten Cu-Schicht werden mit einer dritten Cu-Schicht versehen,
- die metallisierten Bohrungen werden mit einem Isoliermaterial oder mit einem Leitmaterial dadurch vollständig gefüllt, daß das Isoliermaterial bzw. das Leitmaterial auf die freiliegende Oberfläche der dritten Cu-Schicht aufgerollt oder mit einer Rakel aufgestrichen wird,
- die erste und die zweite Cu-Schicht werden zusammen mit der dritten Cu-Schicht entfernt,
- über die verbleibenden Cu-Folien überstehende Teile des Isoliermaterials oder des Leitmaterials werden nach dessen Aushärten entfernt und somit die Oberflächen der Cu-Folien planarisiert, und
- die Cu-Folien werden in üblicher Weise zur Herstellung von Leitungsmustern strukturiert.

Nach einer bevorzugten Ausgestaltung der ersten Variante der Erfindung erfolgt das Aushärten des Isoliermaterials bzw. des Leitmaterials schon vor dem Entfernen der ersten, zweiten und dritten Cu-Schicht.

In der FR-A 23 07 438, die der DE-A 25 15 706 und der AU-A 11 799/76 entspricht, ist ein Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten beschrieben:
- das Basis-Material ist ein Dünnschichtkupfer-Laminat, das
   -- auf der ersten und der zweiten Oberfläche mit einer ersten bzw. mit einer zweiten Cu-Folie versehen worden ist,
- es werden die Bohrungen erzeugt,
- auf die jeweilige Wand der Bohrungen wird eine erste Cu-Schicht und auf die freiliegende Oberfläche der ersten bzw. der zweiten Cu-Folie wird eine zweite bzw. eine dritte Cu-Schicht in einem einzigen Schritt aufgebracht,
- die erste und die zweite Cu-Folie werden zusammen mit der zweiten und der dritten Cu-Schicht durch Abziehen entfernt, und
- die erste Cu-Schicht in den Bohrungen wird mittels Masken verstärkt.

Bei diesem Verfahren werden die Bohrungen nicht gefüllt, sondern sind dann, wenn die Cu-Folien zusammen mit den Cu-Schichten abgezogen werden, offen. Wie Versuche gezeigt haben, führt dies aber dazu, daß sich am Rand der Bohrungen unregelmäßige Abrißkanten bilden. Diese sind jedoch unerwünscht.

In der US-A 31 63 588 ist ein ähnliches Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten beschrieben:
- das Basis-Material ist auf der ersten und der zweiten Oberfläche mit einer ersten bzw. mit einer zweiten Cu-Folie versehen worden,
- darauf wird eine erste bzw. eine zweite Kunststoffschicht aufgebracht,
- es werden die Bohrungen erzeugt, die durch das Basis-Material, die Cu-Folien und die Kunststoff-Schichten hindurchgehen, so daß eine jeweilige Wandung der Bohrungen aus einem im Basis-Material liegenden ersten Teil, einem in den Cu-Folien liegenden zweiten und dritten Teil sowie aus einem in den Kunststoff-Schichten liegenden vierten und fünften Teil besteht,
- die Wandungen der Bohrungen und dazu benachbarte Teile auf den Oberflächen der Kunststoff-Schichten werden durch Plattieren metallisiert,
- die Kunststoff-Schichten werden zusammen mit den benachbarten Teilen und den vierten und fünften Teilen der Wandungen entfernt, und
- die Cu-Folien werden in üblicher Weise zur Herstellung von Leitungsmustern strukturiert.

Bei diesem Verfahren werden die Bohrungen ebenfalls nicht gefüllt, sondern sind dann, wenn die Cu-Folien zusammen mit den Cu-Schichten bzw. die Kunststoff-Schichten abgezogen werden, offen. Wie Versuche gezeigt haben, führt auch dies dazu, daß sich am Rand der Bohrungen wiederum unregelmäßige Abrißkanten bilden. Diese sind jedoch unerwünscht und werden daher in einem weiteren Metallisierungsschritt nochmals plattiert.

Zur Lösung der oben geschilderten Probleme besteht eine zweite Variante der Erfindung in einem Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten:
- das Basis-Material wird
   -- entweder auf der ersten und/oder auf der zweiten Oberfläche mit einer ersten bzw. mit einer zweiten zweischichtigen Folie, von der eine erste Schicht aus einer Cu-Folie und eine zweite Schicht aus einer metallisierbaren Acrylnitril-Butadien-Styrol-Mischpolymerisat-Schicht besteht, derart verpreßt, daß die Cu-Folien am Basis-Material gut haften,
   -- oder mit einer ersten bzw. mit einer zweiten Cu-Folie verpreßt, und darauf wird eine erste bzw. eine zweite metallisierbare Acrylnitril-Butadien-Styrol-Mischpolymerisat-Schicht aufgebracht,
- es werden die Bohrungen erzeugt,
- diese und die freiliegende Oberfläche der ersten bzw. der zweiten metallisierbaren Acrylnitril-Butadien-Styrol-Mischpolymerisat-Schicht werden mit einer ersten Cu-Schicht versehen,
- die metallisierten Bohrungen werden mit einem Isoliermaterial oder mit einem Leitmaterial dadurch vollständig gefüllt, daß das Isoliermaterial bzw. das Leitmaterial auf die freiliegende Oberfläche der ersten Cu-Schicht aufgerollt oder mit einer Rakel aufgestrichen wird,
- die erste bzw. die zweite metallisierbare Acrylnitril-Butadien-Styrol-Mischpolymerisat-Schicht werden zusammen mit der ersten Cu-Schicht entfernt,
- über die verbleibenden Cu-Folien überstehende Teile des Isoliermaterials oder des Leitmaterials werden nach dessen Aushärten entfernt und somit die Oberflächen der Cu-Folien planarisiert, und
- die Cu-Folien werden in üblicher Weise zur Herstellung von Leitungsmustern strukturiert.

Nach einer bevorzugten Ausgestaltung der zweiten Variante Erfindung erfolgt das Aushärten des Isoliermaterials bzw. des Leitmaterials schon vor dem Entfernen der ersten und der zweiten metallisierbaren Acrylnitril-Butadien-Styrol-Mischpolymerisat-Schicht sowie der ersten Cu-Schicht.

In "IBM Technical Disclosure Bulletin", Dez. 1968, Seite 733 ist ein Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten:
- das Basis-Material ist auf der ersten und der zweiten Oberfläche mit einer ersten bzw. mit einer zweiten Cu-Folie versehen worden,
- darauf wird eine erste bzw. eine zweite Kunststoffschicht aufgebracht,
- es werden die Bohrungen erzeugt, die durch das Basis-Material, die Cu-Folien und die Kunststoff-Schichten hindurchgehen, so daß eine jeweilige Wandung der Bohrungen aus einem im Basis-Material liegenden ersten Teil, einem in den Cu-Folien liegenden zweiten und dritten Teil sowie aus einem in den Kunststoff-Schichten liegenden vierten und fünften Teil besteht,
- lediglich die Wandungen der Bohrungen werden durch Plattieren metallisiert,
- die metallisierten Bohrungen werden mit einem Isoliermaterial derart vollständig gefüllt, daß dieses auf die freiliegende Oberfläche der ersten bzw. zweiten Cu-Schicht leicht überquillt und einen Pilzkopf bildet
- das Isoliermaterial wird ausgehärtet,
- die Kunststoff-Schichten werden zusammen mit den Pilzköpfen entfernt, so daß die vierten und fünften Teile der Wandung als "Copper Burrs" und sie füllende Teile des Isoliermaterials als "Resin Stubs" stehenbleiben,
- die Copper Burrs und die Resin Stubs werden entfernt und somit die Oberflächen der Cu-Folien planarisiert, und
- die Cu-Folien werden in üblicher Weise zur Herstellung von Leitungsmustern strukturiert.

Überstehende Teile, wie z.B. Copper Burrs oder Resin Stubs, werden in der Leiterplattentechnik meist durch Bürsten entfernt. Sollen Copper Burrs und Resin Stubs jedoch gemeinsam entfernt werden, wie dies bei dem in "IBM Technical Disclosure Bulletin" beschriebenen Verfahren erforderlich ist, so ist dies deswegen schwierig, weil nicht nur von ihrer chemischen Zusammensetzung her, sondern auch von ihrer mechanischen Bearbeitbarkeit her extrem unterschiedliche Materialien entfernt werden müssen.

Zur Lösung der oben geschilderten Probleme besteht eine dritte Variante der Erfindung in einem Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten:
- das Basis-Material wird
   -- entweder auf der ersten und/oder auf der zweiten Oberfläche mit einer ersten bzw. mit einer zweiten zweischichtigen Folie, von der eine erste Schicht aus einer Cu-Folie und eine zweite Schicht aus einer selbsthaftenden Kunststoff-Folie besteht, derart verpreßt, daß die Cu-Folien am Basis-Material gut haften,
   -- oder mit einer ersten bzw. mit einer zweiten Cu-Folie verpreßt, und darauf wird eine erste bzw. eine zweite selbsthaftende Kunststoff-Folie aufgebracht,
- es werden die Bohrungen erzeugt,
- diese werden mit einem Leitmaterial dadurch vollständig gefüllt, daß dieses auf die freiliegende Oberfläche der selbsthaftenden Kunststoff-Schichten aufgerollt oder mit einer Rakel aufgestrichen wird,
- die selbsthaftenden Kunststoff-Folien werden entfernt,
- über die verbleibenden Cu-Folien überstehende Teile des Leitmaterials werden nach dessen Aushärten entfernt und somit die Oberflächen der Cu-Folien planarisiert, und
- die Cu-Folien werden in üblicher Weise zur Herstellung von Leitungsmustern strukturiert.

Nach einer bevorzugten Ausgestaltung der dritten Variante der Erfindung erfolgt das Aushärten des Leitmaterials schon vor dem Entfernen der selbsthaftenden Kunststoff-Folien.

In der US-A 43 83 363 ist ein Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten beschrieben:
- die Bohrungen werden im noch unbeschichteten Basis-Material erzeugt,
- die Bohrungen werden in einem maskenlosen Füllschritt mit einem Leitmaterial vollständig gefüllt,
- das Basis-Material wird mit mindestens einer Cu-Schicht versehen, und
- die Cu-Schicht wird zur Herstellung von Leitungsmustern strukturiert.

In der US-A 43 83 363 ist ein weiteres Verfahren zum Herstellen von Leiterplatten mit mindestens einer elektrisch leitenden Durchkontaktierung, die in einer Bohrung eines isolierenden Basis-Materials von einer ersten Oberfläche zu einer zweiten Oberfläche verläuft, mit folgenden Schritten beschrieben:
- die Bohrungen werden im schon mit mindestens einer Cu-Schicht versehenen Basis-Material erzeugt,
- die Bohrungen werden in einem maskenlosen Füllschritt mit einem Leitmaterial vollständig gefüllt, und
- die Cu-Schicht wird zur Herstellung von Leitungsmustern strukturiert.

In der US-A 43 83 363 ist somit lediglich das Füllen von Bohrungen in Leiterplatten mittels eines Leitmaterials an sich beschrieben.

Bei bevorzugten Weiterbildungen der drei Varianten der Erfindung und deren Ausgestaltungen wird, bevor die Cu-Folien zur Herstellung von Leitungsmustern strukturiert werden, auf die Cu-Folien und die planar verschlossenen Durchkontaktierungen eine zusätzliche leitende Schicht aufgebracht.

Der Grundgedanke der Erfindung besteht darin, zunächst eine im Verlauf des Verfahrens wieder zu entfernende Doppelschicht vorzusehen, dann die Bohrungen durch großflächiges Aufbringen eines geeigneten Materials (Isolier- oder Leitmaterials) vollständig zu füllen und zu verschließen, dann die Doppelschicht zusammen mit den darauf befindlichen Teilen des Materials zu entfernen, so daß nur Stubs dieses Materials allein über die Bohrungen überstehen, und dann die Stubs, die somit nur aus einem einheitlichen Material bestehen, zu entfernen und dadurch die Oberflächen der Leiterplatte planar zu machen.

Ein wesentlicher Vorteil der Varianten der Erfindung besteht darin, daß vollständig gefüllte Bohrungen mit planarer Oberfläche auf einfachere Weise, als es aus dem oben referierten Stand der Technik hervorgeht, erzeugt werden können. Die übliche Strukturierung der Leiterplatte zur Herstellung eines gewünschten Layouts kann damit wie an einer per se planaren Leiterplatte vorgenommen werden. Ferner sind keine Rißbildungen zu erwarten.

Ein weiterer Vorteil der Erfindung besteht darin, daß bei deren erster und deren zweiter Variante die in allen Bohrungen einer Leiterplatte aufgebrachten Cu-Schichten praktisch dieselbe Dicke haben.

Die Erfindung wird nun anhand der Figuren der Zeichnung näher erläutert, in der Ausführungsbeispiele einer einzigen Durchkontaktierung perspektivisch, nicht maßstäblich und in Zuständen dargestellt sind, wie sie sich nach einzelnen Schritten ders Verfahrensvarianten der Erfindung ergeben. Anhand einer Figur erläuterte Bezugszeichen werden in folgenden Figuren der Übersichtlichkeit halber nur wiederholt, falls es für das unmittelbare Verständnis dieser folgenden Figur erforderlich ist.
- Fig. 1: zeigt einen Ausschnitt aus einer beschichteten Leiterplatte,
- Fig. 2: zeigt die beschichtete Leiterplatte von Fig. 1 mit einer darin angebrachten, im Schnitt dargestellten Bohrung,
- Fig. 3: zeigt die gebohrte Leiterplatte von Fig. 2 mit einer auf Cu-Schichten und in der Bohrung aufgebrachten Metallisierung,
- Fig. 4: zeigt die gebohrte Leiterplatte von Fig. 2 mit einer auf Acrylnitril-Butadien-Styrol-Mischpolymerisat-Schichten und in der Bohrung aufgebrachten Metallisierung,
- Fig. 5: zeigt die Leiterplatte von Fig. 3 mit einem in die Bohrung eingebrachten Isoliermaterial bzw. Leitmaterial,
- Fig. 6: zeigt die Leiterplatte von Fig. 5 nach dem Entfernen der Cu- bzw. Acrylnitril-Butadien-Styrol-Mischpolymerisat-Schichten,
- Fig. 7: zeigt die Leiterplatte von Fig. 6 nach dem Entfernen von Stubs des Isoliermaterials bzw. Leitmaterials,
- Fig. 8: zeigt die gebohrte Leiterplatte von Fig. 2 mit darin eingebrachtem Leitmaterial,
- Fig. 9: zeigt die Leiterplatte von Fig. 8 nach dem Entfernen der selbsthaftenden Kunststoff-Folie,
- Fig. 10: zeigt die Leiterplatte von Fig. 9 nach dem Entfernen von Stubs des Leitmaterials,
- Fig. 11: zeigt die Leiterplatte von Fig. 7 nach dem Aufbringen einer zusätzlichen leitenden Schicht, und
- Fig. 12: zeigt die Leiterplatte von Fig. 10 nach dem Aufbringen einer zusätzlichen leitenden Schicht.

Es sei vorausgeschickt, daß in den Figuren ein Ausschnitt aus einer beidseits kaschierten, doppelseitigen Leiterplatte dargestellt ist, an der die Verfahrensschritte vorgenommen werden. Die Erfindung ist selbstverständlich auch bei nur einseitig kaschierten Leiterplatten oder bei mehrlagigen Leiterplatten anwendbar, die außen einseitig oder zweiseitig ein Leitungsmuster aufweisen.

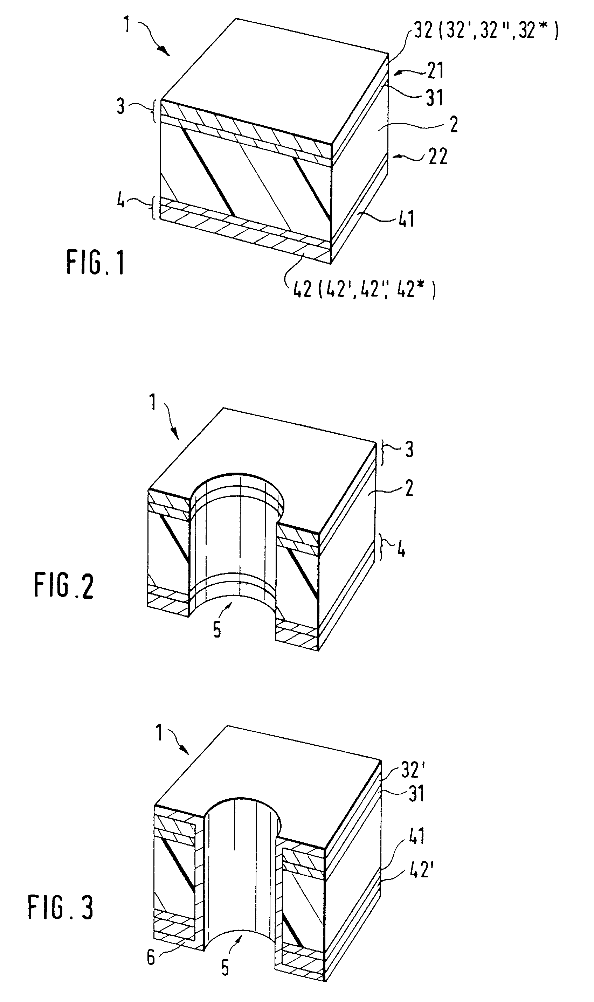

In Fig. 1 ist ein Zustand einer Leiterplatte 1 dargestellt, wie er sich nach folgenden Verfahrensschritten ergibt: Ein isolierendes Basis-Material 2 ist auf einer ersten und auf einer zweiten Oberfläche 21, 22 mit einer ersten bzw. mit einer zweiten zweischichtigen Folie 3, 4 verpreßt.

Die Folien 3 bzw. 4 bestehen aus einer ersten Schicht, die eine Cu-Folie 31 bzw. 41 ist, und aus einer zweiten Schicht 32 bzw. 42, die nach der ersten Variante der Erfindung eine erste bzw. eine zweite Cu-Schicht 32' bzw. 42' oder nach der zweiten Variante der Erfindung eine erste bzw. eine zweite metallisierbare Acrylnitril-Butadien-Styrol-Mischpolymerisat-Schicht 32" bzw. 42" oder nach der dritten Variante der Erfindung eine selbsthaftende Kunststoff-Folie 32* bzw.42* ist.

Die erste und die zweite zweischichtige Folie 3 bzw. 4 sind mit dem Basis-Material derart verpreßt, daß die Cu-Folie 31 bzw. 41 mit dem Basis-Material mechanisch unlösbar verbunden, jedoch chemisch strukturierbar ist, wie dies für Cu-kaschierte Leiterplatten erforderlich und üblich ist.

In Fig. 2 ist die beschichtete Leiterplatte von Fig. 1 mit einer darin angebrachten Bohrung 5 gezeigt, die im Schnitt dargestellt ist. Die Bohrung geht durch das Basis-Material 2 und die beiden zweischichtigen Folien 3, 4 vollständig hindurch.

In Fig. 3 ist der Zustand gezeigt, nachdem die gebohrte Leiterplatte 1 von Fig. 2 einschließlich der Bohrung 5 nach der ersten Variante der Erfindung, z.B. naßchemisch galvanisch oder naßchemisch stromlos, mit Cu in gleichmäßiger Schichtdicke metallisiert worden ist. Die Wandung der Bohrung 5 und die Außenseiten der Cu-Schichten 32', 42' sind nun mit einer dritten Cu-Schicht 6 durchgehend versehen.

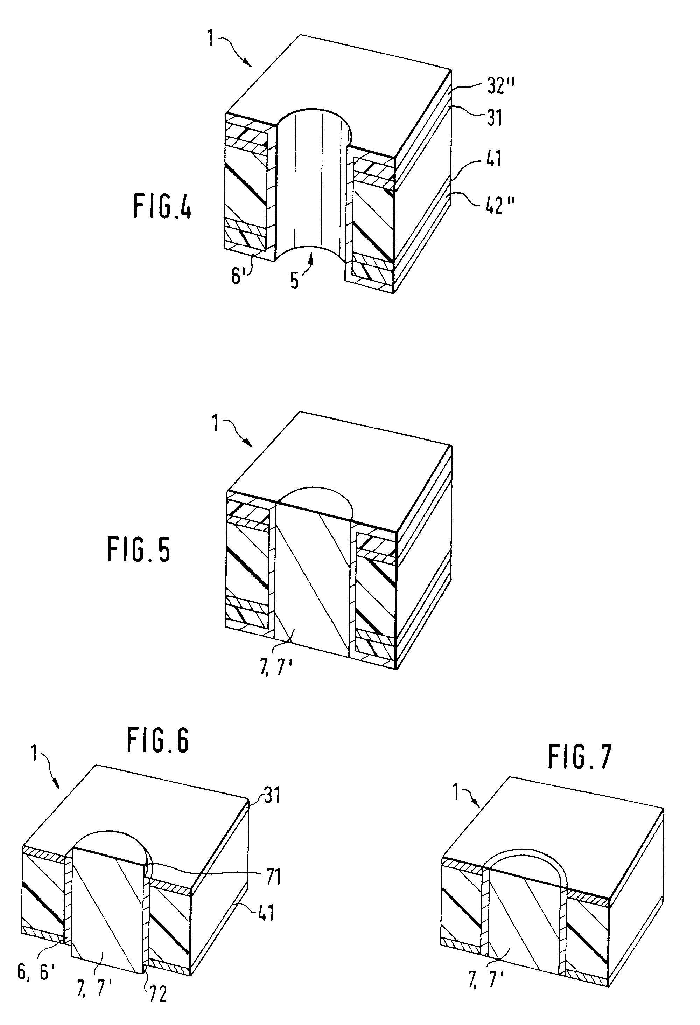

In Fig. 4 ist der Zustand gezeigt, nachdem die gebohrte Leiterplatte 1 von Fig. 2 einschließlich der Bohrung 5 nach der zweiten Variante der Erfindung, z.B. naßchemisch galvanisch oder naßchemisch stromlos, mit Cu in gleichmäßiger Schichtdicke metallisiert worden ist. Die Innenseite der Bohrung 5 und die Außenseiten der Acrylnitril-Butadien-Styrol-Mischpolymerisat-Schichten 32" bzw. 42" sind nun mit einer ersten Cu-Schicht 6' durchgehend versehen.

Die Fig. 5 zeigt den Zustand, nachdem die Leiterplatte 1 von Fig. 3 oder die Leiterplatte 1 von Fig. 4 zusammen mit der metallisierten Bohrung 5 mit einem Isoliermaterial 7 oder mit einem Leitmaterial 7' vollständig gefüllt worden ist. Dieses Füllen erfolgte durch ein siebdruck-ähnliches Aufstreichen mit der oben erwähnten Rakel oder durch Aufrollen. Alle an einer konkreten Leiterplatte erzeugten Bohrungen werden durch diesen Schritt mit dem Isoliermaterial 7 oder dem Leitmaterial 7' vollständig gefüllt.

Die Fig. 6 zeigt den Zustand der Leiterplatte 1 von Fig. 5, nachdem die Cu-Schichten 32', 42' zusammen mit den darauf befindlichen Teilen der Leitschicht 6 (entsprechend Fig. 3) bzw. die Acrylnitril-Butadien-Styrol-Mischpolymerisat-Schichten 32" bzw. 42" (entsprechend Fig. 4), z.B. durch Abziehen, entfernt worden sind.

An den nunmehr freiliegenden Oberflächen der Leiterplatte 1 verbleiben nur noch die Cu-Folien 31, 41, der in der Bohrung liegende Teil der Leitschicht 6 bzw. 6' und das Isoliermaterial 7 bzw. das Leitmaterial 7'. Dieses steht über die Oberflächen der Cu-Folien mit Stubs 71, 72 vor.

Die Fig. 7 zeigt den Zustand der Leiterplatte 1 von Fig. 6, nachdem die Stubs 71, 72 des Isoliermaterials 7 bzw. des Leitmaterials 7' nach dessen Aushärten entfernt und somit die Oberflächen der Cu-Folien planarisiert worden sind. Dies geschieht bevorzugt durch Bürsten. Die Cu-Folien 31, 41 können nun in üblicher Weise zur Herstellung von Leitungsmustern strukturiert werden.

Anstatt die Cu-Schichten 32', 42' zusammen mit den darauf befindlichen Teilen der Leitschicht 6 bzw. die Acrylnitril-Butadien-Styrol-Mischpolymerisat-Schichten 32", 42" schon vor dem Aushärten des Isoliermaterials 7 bzw. Leitmaterials 7' zu entfernen, kann es auch von Vorteil sein, das Isoliermaterial bzw. das Leitmaterial nach dem Einbringen in die Bohrungen zunächst auszuhärten und erst danach die Cu-Schichten 32', 42' zusammen mit den darauf befindlichen Teilen der Leitschicht 6 bzw. Acrylnitril-Butadien-Styrol-Mischpolymerisat-Schichten 32", 42" zusammen mit den darauf befindlichen Teilen der Leitschicht 6' zu entfernen.

Bei der nun zu erläuternden dritten Variante der Erfindung wird wieder von einem Zustand entsprechend Fig. 2 ausgegangen. Allerdings ist die Cu-Folie 31 bzw. 41 hier mit einer selbsthaftenden Kunststoff-Folie 32* bzw. 42* beschichtet.

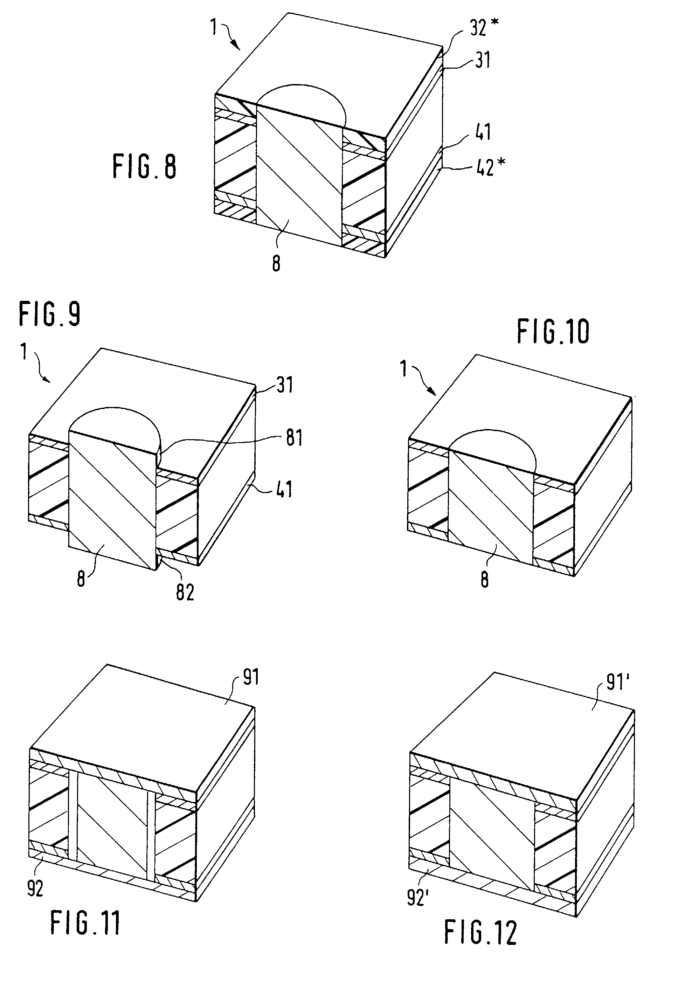

Die Fig. 8 zeigt den Zustand, nachdem die Leiterplatte 1 von Fig. 2 in einem maskenlosen Füllschritt mit einem Leitmaterial 8 vollständig gefüllt worden ist. Dies erfolgte wieder durch ein siebdruck-ähnliches Aufstreichen mit der oben erwähnten Rakel oder durch Aufrollen. Alle an einer konkreten Leiterplatte erzeugten Bohrungen werden durch diesen Schritt mit dem Leitmaterial 8 vollständig gefüllt.

Die Fig. 9 zeigt den Zustand der Leiterplatte 1 von Fig. 8, nachdem die selbsthaftenden Kunststoff-Folien 32*, 42*, z.B. durch Abziehen, entfernt worden sind. An den nunmehr freiliegenden Oberflächen der Leiterplatte 1 verbleiben nur noch die Cu-Folien 21, 22 und das Leitmaterial 8. Dieses steht über die Oberflächen der Cu-Folien mit Stubs 81, 82 vor.

Die Fig. 10 zeigt den Zustand der Leiterplatte 1 von Fig. 9, nachdem die Stubs 81, 82 des Leitmaterials 8 nach dessen Aushärten entfernt und somit die Oberflächen der Cu-Folien planarisiert worden sind. Dies geschieht wieder bevorzugt durch Bürsten. Die Cu-Folien 31, 41 können nun in üblicher Weise zur Herstellung von Leitungsmustern strukturiert werden.

Anstatt die selbsthaftende Kunststoff-Folien 32*, 42* schon vor dem Aushärten des Leitmaterials 8 zu entfernen, kann es auch von Vorteil sein, das Leitmaterial nach dem Einbringen in die Bohrungen zunächst auszuhärten und erst danach die selbsthaftende Kunststoff-Folien 32*, 42* zu entfernen.

Die Fig. 11 und 12 zeigen noch eine bevorzugte Weiterbildung der drei Varianten der Erfindung. So ist in Fig. 11 die Leiterplatte von Fig. 7 noch mit einer zusätzlichen leitenden Schicht 91 bzw. 92 versehen worden, die nun in üblicher Weise zur Herstellung von Leitungsmustern strukturiert werden kann.

In Fig. 12 ist die Leiterplatte von Fig. 10 noch mit einer zusätzlichen leitenden Schicht 91' bzw. 92' versehen worden, die nun in üblicher Weise zur Herstellung von Leitungsmustern strukturiert werden kann.

Bei allen Varianten der Erfindung ist es auch möglich, anstatt die zweischichtige Folie 3 bzw. 4 zu verwenden, das Basis-Material zunächst mit einer Cu-Folie zu verpressen und auf eine freiliegende Oberfläche dieser - somit einschichtigen - Cu-Folie nach der ersten Variante der Erfindung eine Cu-Schicht oder nach der zweiten Variante der Erfindung eine metallisierbare Acrylnitril-Butadien-Styrol-Mischpolymerisat-Schicht oder nach der dritten Variante der Erfindung eine selbsthaftende Kunststoff-Folie aufzubringen.

Folgende Materialien werden bei der Erfindung bevorzugt verwendet:
- Als Basis-Material: übliches FR 4 (FR = flame retarding);
- als Isoliermaterial: handelsübliche Epoxidharze mit hohem Feststoffanteil;
- als Leitmaterial: handelsüblicher Ag- oder Cu-haltiger Leitkleber, wie er z.B. zum Befestigen der oben erwähnten SMD-Komponenten auf Leiterplatten benutzt wird,;
- als zusätzliche leitende Schicht: Cu.

## Patentansprüche

1. Verfahren zum Herstellen von Leiterplatten (1) mit mindestens einer elektrisch leitenden Durchkontaktierung, die in einer Bohrung eines isolierenden Basis-Materials (2) von einer ersten Oberfläche (21) zu einer zweiten Oberfläche (22) verläuft, mit folgenden Schritten:
- das Basis-Material wird
-- entweder auf der ersten und/oder auf der zweiten Oberfläche mit einer ersten bzw. mit einer zweiten zweischichtigen Folie (3, 4), von der eine erste Schicht aus einer Cu-Folie (31, 41) und eine zweite Schicht aus einer Cu-Schicht (32', 42') besteht, derart verpreßt, daß die Cu-Folien am Basis-Material gut haften,
-- oder mit einer ersten bzw. mit einer zweiten Cu-Folie verpreßt, und darauf wird eine erste bzw. eine zweite Cu-Schicht aufgebracht,
- es werden die Bohrungen erzeugt,
- diese und die freiliegende Oberfläche der ersten bzw. der zweiten Cu-Schicht werden mit einer dritten Cu-Schicht (6) versehen,
- die metallisierten Bohrungen werden mit einem Isoliermaterial (7) oder mit einem Leitmaterial (7') dadurch vollständig gefüllt, daß das Isoliermaterial (7) bzw. das Leitmaterial (7') auf die freiliegende Oberfläche der dritten (6) Cu-Schicht aufgerollt oder mit einer Rakel aufgestrichen wird,
- die erste und die zweite Cu-Schicht werden zusammen mit der dritten Cu-Schicht entfernt,
- über die verbleibenden Cu-Folien überstehende Teile (71, 72) des Isoliermaterials oder des Leitmaterials werden nach dessen Aushärten entfernt und somit die Oberflächen der Cu-Folien planarisiert, und
- die Cu-Folien werden in üblicher Weise zur Herstellung von Leitungsmustern strukturiert.

2. Verfahren zum Herstellen von Leiterplatten (1) mit mindestens einer elektrisch leitenden Durchkontaktierung, die in einer Bohrung eines isolierenden Basis-Materials (2) von einer ersten Oberfläche (21) zu einer zweiten Oberfläche (22) verläuft, mit folgenden Schritten:
- das Basis-Material wird
-- entweder auf der ersten und/oder auf der zweiten Oberfläche mit einer ersten bzw. mit einer zweiten zweischichtigen Folie (3, 4), von der eine erste Schicht aus einer Cu-Folie (31, 41) und eine zweite Schicht aus einer metallisierbaren Acrylnitril-Butadien-Styrol-Mischpolymerisat-Schicht (32', 42') besteht, derart verpreßt, daß die Cu-Folien am Basis-Material gut haften,
-- oder mit einer ersten bzw. mit einer zweiten Cu-Folie verpreßt, und darauf wird eine erste bzw. eine zweite metallisierbare Acrylnitril-Butadien-Styrol-Mischpolymerisat-Schicht aufgebracht,
- es werden die Bohrungen erzeugt,
- diese und die freiliegende Oberfläche der ersten bzw. der zweiten metallisierbaren Acrylnitril-Butadien-Styrol-Mischpolymerisat-Schicht werden mit einer ersten Cu-Schicht (6') versehen,
- die metallisierten Bohrungen werden mit einem Isoliermaterial (7) oder mit einem Leitmaterial (7') dadurch vollständig gefüllt, daß das Isoliermaterial (7) bzw. das Leitmaterial (7') auf die freiliegende Oberfläche der ersten Cu-Schicht (6') aufgerollt oder mit einer Rakel aufgestrichen wird,
- die erste bzw. die zweite metallisierbare Acrylnitril-Butadien-Styrol-Mischpolymerisat-Schicht werden zusammen mit der ersten und der zweiten Cu-Schicht entfernt,
- über die verbleibenden Cu-Folien überstehende Teile (71, 72) des Isoliermaterials oder des Leitmaterials werden nach dessen Aushärten entfernt und somit die Oberflächen der Cu-Folien planarisiert, und
- die Cu-Folien werden in üblicher Weise zur Herstellung von Leitungsmustern strukturiert.

3. Verfahren zum Herstellen von Leiterplatten (1) mit mindestens einer elektrisch leitenden Durchkontaktierung, die in einer Bohrung eines isolierenden Basis-Materials (2) von einer ersten Oberfläche (21) zu einer zweiten Oberfläche (22) verläuft, mit folgenden Schritten:
- das Basis-Material wird
-- entweder auf der ersten und/oder auf der zweiten Oberfläche mit einer ersten bzw. mit einer zweiten zweischichtigen Folie (3, 4), von der eine erste Schicht aus einer Cu-Folie (31, 41) und eine zweite Schicht aus einer selbsthaftenden Kunststoff-Folie (32*, 42*) besteht, derart verpreßt, daß die Cu-Folien am Basis-Material gut haften,
-- oder mit einer ersten bzw. mit einer zweiten Cu-Folie verpreßt, und darauf wird eine erste bzw. eine zweite selbsthaftende Kunststoff-Folie aufgebracht,
- es werden die Bohrungen erzeugt,
- diese werden mit einem Leitmaterial dadurch vollständig gefüllt, daß dieses auf die freiliegende Oberfläche der selbsthaftenden Kunststoff-Schichten aufgerollt oder mit einer Rakel aufgestrichen wird,
- die selbsthaftenden Kunststoff-Folien werden entfernt,
- über die verbleibenden Cu-Folien überstehende Teile (81, 82) des Leitmaterials werden nach dessen Aushärten entfernt und somit die Oberflächen der Cu-Folien planarisiert, und
- die Cu-Folien werden in üblicher Weise zur Herstellung von Leitungsmustern strukturiert.

4. Verfahren nach Anspruch 1, bei dem das Aushärten des Isoliermaterials bzw. des Leitmaterials schon vor dem Entfernen der ersten, zweiten und dritten Cu-Schicht erfolgt.

5. Verfahren nach Anspruch 2, bei dem das Aushärten des Isoliermaterials bzw. des Leitmaterials schon vor dem Entfernen der ersten und der zweiten metallisierbaren Acrylnitril-Butadien-Styrol-Mischpolymerisat-Schicht sowie der ersten Cu-Schicht erfolgt.

6. Verfahren nach Anspruch 3, bei dem das Aushärten des Leitmaterials schon vor dem Entfernen der selbsthaftenden Kunststoff-Folien erfolgt.

7. Verfahren nach einem der Ansprüche 1 bis 6, bei dem, bevor die Cu-Folien zur Herstellung von Leitungsmustern strukturiert werden, auf die Cu-Folien und die planar verschlossenen Durchkontaktierungen eine zusätzliche leitende Schicht aufgebracht wird.
